# EUROPEAN PATENT SPECIFICATION

(11) **EP 4 518 594 B1**
(45) Date of publication and mention of the grant of the patent: **17.12.2025**
(21) Application number: 23306456.7
(22) Date of filing: 31.08.2023
(51) Int. Cl.: H05K 7/14, H02G 3/04

(54) **MULTI-LEVEL MODULAR DATACENTER ELECTRIC INFRASTRUCTURE AND LAYOUT CONFIGURATION**
MEHRSTUFIGE MODULARE ELEKTRISCHE DATENCENTERINFRASTRUKTUR UND LAYOUTKONFIGURATION
INFRASTRUCTURE ÉLECTRIQUE MODULAIRE DE CENTRE DE DONNÉES MULTINIVEAU ET CONFIGURATION DE DISPOSITION

(43) Date of publication of application: 05.03.2025
(73) Proprietor: OVH, 59100 Roubaix (FR)
(72) Inventor: CHEHADE, Ali, 59283 Moncheaux (FR); BAUCHART, Grégory Francis Louis, 59150 Wattrelos (FR); LACHEVRE, Maxime, 59510 Hem (FR)
(74) Representative: BCF Global

(56) References cited:
- WO-A1-2011/159150
- AU-A1- 2011 237 755
- CN-A- 102 812 192
- DE-A1- 102021 109 550
- US-A1- 2009 229 194

## Description

### FIELD OF TECHNOLOGY

The present technology relates to overall datacenter configurations, and in particular, to an electric infrastructure and layout configuration for multi-level modular datacenter configurations.

### BACKGROUND

In efforts to process vast amounts of data in near-real time, permanent datacenters house and service multitudes of racks containing electronic equipment, such as, computer server assemblies, specialized processors, memory components, high-speed network modules, *etc.* as well as supporting infrastructure equipment, such as, power facilities, air handling systems, liquid cooling structures, *etc.*

The market demand to service the ever-increasing data processing requirements eventually leads to the need of more datacenters. However, the initial investment costs along with the construction time associated with the installation of permanent datacenters can be prohibitive.

To counter the high cost of constructing permanent datacenters, various solutions have been proposed directed to the installation of "modular datacenters," in which datacenter electronic computing equipment and supporting infrastructure equipment are incorporated in movable trailers or shipping containers. Depending on data processing demands, multiple trailers/shipping containers may be deployed and arranged in different single level geometric configurations that spread across a sizeable area. Therefore, in contrast to permanent datacenters, modular datacenters provide substantial reductions in overall construction time and installation costs to provide speedier turn-key operations.

However, situations may exist in which certain space-limited geographical areas having high data processing needs (*e.g*., urban areas, research campuses, *etc*.), may not be able to accommodate sprawling modular datacenter configurations. It may, therefore, be desirable to provide multilevel modular datacenter configurations having smaller footprints. It may further be desirable to provide an electric infrastructure and configuration layout to optimize the limited space within these multilevel modular datacenters.

For example, WO 2011/159150 is directed to a data centre system wherein the data centre functions are provided by separate containerized modules. In general a data centre can be described by the functions it needs to provide; such functions comprise: a hot floor for placement of data servers, an energy supply system with backup system for providing uninterrupted power supply, a cooling system for air-conditioning, a cooling system energy supply for providing power to the cooling system, a distribution system for distribution and linkage of electrical power and of data capacity, and general facilities such as fuel supply and storage, electrical grid connection, fencing and gate control and a control room.

Similarly, US Pub. No. 2009/0229194 is directed to a modular containment structure that houses and maintains for operation various types of information technologies (IT) equipment, such as computer servers, Network Area Storage devices, data communication routers and switches and the support equipment to make them operational such as electrical switchboards, high precision air conditioning, and uninterruptible power supply are within the modular containment structure, the containment structure offers a secured and stable environment, which includes minimizing any external temperature transmission into the containment structure, regardless of the external environmental conditions.

As another example, WO 2011/127125 is directed to a cooling container comprising a container housing a chilled water storage tank including a first interface for receiving chilled water. The chilled water tank has a plurality of straight pipes joined by elbows connections to provide a folded path, the full path length being greater than the length of the container housing, and a second interface for outputting the chilled water. A number of interfaces within the container housing are configured to receive a chiller module or a free cool unit.

It is to be noted that the subject matter discussed in the background section should not be assumed to be prior art merely as a result of its mention in the background section. Similarly, the issues mentioned in the background section should not be interpreted as having been recognized in the prior art.

### SUMMARY

Embodiments of the present technology have been developed based on certain drawbacks associated with conventional datacenter implementations.

The present invention provides a multi-level modular datacenter as defined in the independent claim. Further preferred embodiments are disclosed in the dependent claims.

Accordingly, the present invention provides a multi-level modular datacenter for data processing equipment that comprises a lower containment unit configured to house at least one uninterruptible power supply unit (UPS), at least one power distribution cabinet system (PDCS), and at least one upper porthole disposed on a roof surface of the lower containment unit; an upper containment unit arranged to be aligned and vertically disposed directly above the lower containment unit, the upper containment unit configured to house at least one battery assembly, at least one transformer, and at least one lower porthole disposed on a floor surface of the upper containment unit; an electrical distribution infrastructure comprising electrically-communicative cabling to service the lower and upper containment units, the electrical distribution infrastructure configured to enable electrical communications of components within each of the lower and upper containment units and enable electrical communications between components of the lower and upper containment units; and at least one electric conduit component, disposed between the lower containment unit and upper containment unit, configured to be aligned with the at least one upper porthole and the at least one lower porthole to accommodate routing of the electrically-communicative cabling and piping between the lower and upper containment units, wherein the positioning of the at least one battery assembly of the upper containment unit is proximately vertically-aligned with the positioning of the UPS of the lower containment unit and the positioning of the at least one transformer of the upper containment unit is proximately vertically-aligned with the positioning of the PDCS of the lower containment unit.

The multi-level modular datacenter also provides that the PDCS comprises at least one power distribution cabinet (PDC) that housing at least one power distribution cabinet unit (PDCU) in which the PDCU is configured to supply electrical power and be electrically- and communicatively-coupled to the UPS of the lower containment unit and to the battery assembly and transformer of the upper containment unit.

The multi-level modular datacenter further comprises a global monitoring system (GMS) configured to monitor the status of communicatively-coupled operational sensors of various components of the lower and upper containment units that implements a power monitoring subsystem (PMS) configured to monitor status of power and electrical consumption of associated components; a temperature/humidity monitoring subsystem (TMS) configured to monitor status of temperature and humidity levels of associated components, and a building equipment monitoring subsystem (BEMS) configured to monitor status of electrical circuit elements.

The multi-level modular datacenter wherein according to the present invention the at least one electric conduit component is further configured with a vertically-arranged skirt portion to facilitate slidable positioning between the at least one upper porthole and the at least one lower porthole; a horizontally-arranged attachment tab to facilitate secure fastening to the lower containment unit; and one or more of the following material elements: metal sleeves, firestop collars, intumescent strips, water-proof materials, and fire-resistant materials.

The multi-level modular datacenter additionally comprises an air-cooling partition wall disposed on the lower containment unit that operates to separate and isolate the air-cooling operations of the respective first and second sections containing the at least one UPS from the PDCS.

The multi-level modular datacenter also comprises an air-cooling partition wall to separate and isolate the air-cooling operations of the respective sections containing the at least one battery assembly from the at least one transformer.

The multi-level modular datacenter is further configured such that the electrical distribution infrastructure is configured to provide electrical communications by interconnecting the at least one UPS with the at least one PDCS of the lower containment unit and the at least one battery assembly with the at least one transformer of the upper containment unit as well as interconnecting the at least one UPS of the lower containment unit with the at least one battery assembly of the upper containment unit and the at least one PDCS of the lower containment unit with the at least one transformer of the upper containment unit.

In addition, the multi-level modular datacenter further comprises a moisture protection cap structure externally attached on an edge of the roof surface of the lower containment unit configured to divert any moisture from rain or snow away from the at least one electric conduit structure and a junction structure externally disposed on an edge of the floor surface of the upper containment unit, configured to facilitate engagement and provide a stable platform for adjoining an additional upper containment unit.

Implementations of the present technology each have at least one of the above-mentioned objects and/or aspects, but may not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1 depicts a side elevation view of a multilevel modular datacenter, in accordance with non-limiting embodiments of the present disclosure;
FIG. 2 depicts a top view of an internal layout configuration of a lower unit of a multilevel modular datacenter unit, in accordance with non-limiting embodiments of the present disclosure;
FIG. 3 depicts a top view of an internal layout configuration of an upper unit of a multilevel modular datacenter unit, in accordance with non-limiting embodiments of the present disclosure;
FIG. 4 depicts a perspective cross sectional view of an electric conduit structure, in accordance with non-limiting embodiments of the present disclosure;
FIG. 5 depicts a protection cap structure and a junction structure, in accordance with non-limiting embodiments of the present disclosure;
FIG. 6 depicts a functional block diagram of a global monitoring system for a multilevel modular datacenter, in accordance with non-limiting embodiments of the present disclosure; and
FIG. 7 depicts a functional block diagram of an electrical distribution infrastructure for a multilevel modular datacenter, in accordance with non-limiting embodiments of the present disclosure.

### DETAILED DESCRIPTION

The instant disclosure is directed to addressing at least some of the issues associated with space-limited geographical areas having high data processing needs that may not be able to accommodate sprawling modular datacenter configurations. In particular, the instant disclosure presents various embodiments that provide an electric infrastructure and configuration layout to optimize the limited spaces within multilevel modular datacenters.

With these fundamentals in place, we will now consider some non-limiting examples to illustrate the implementations of the various inventive aspects of the present disclosure.

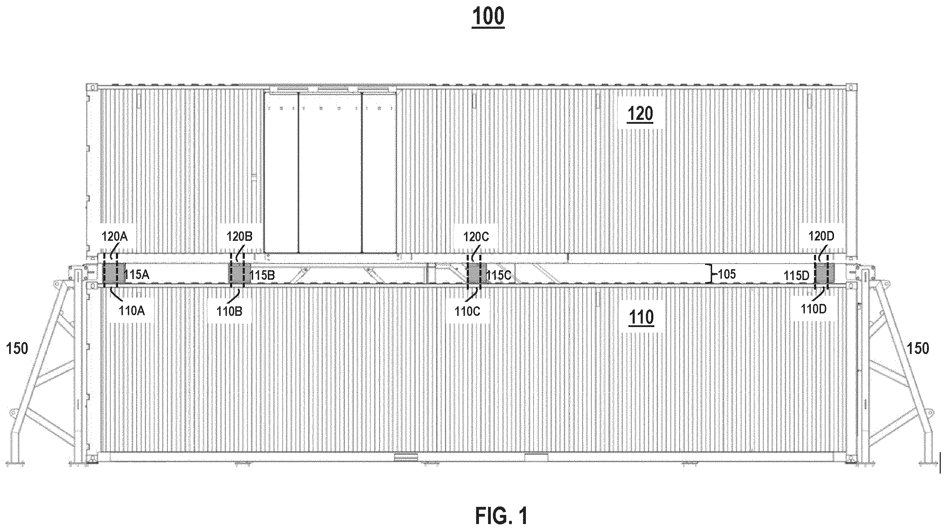

In particular, FIG. 1 depicts a side elevation view of a multilevel modular datacenter 100, in accordance with non-limiting embodiments of the present disclosure. As shown, the multilevel modular datacenter **100** employs a vertically-stacked arrangement comprising a lower containment unit **110** and an upper containment unit **120** that is vertically aligned and disposed directly above the lower containment unit **110.**

The containment units **110, 120** may be embodied by trailers, shipping containers, or other similarly-configured structures. The vertically-stacked arrangement of containment units **110, 120** provides the benefit of a performing high volume data processing operations within a relatively limited footprint.

In the illustrated embodiment, the vertically-stacked multilevel modular datacenter configuration **100** employs support structures **150** proximately positioned along the underside of corner portions of upper containment unit **120.** The vertically-stacked multilevel modular datacenter **100** may also employ support structures proximately positioned along the underside of lateral portions of upper containment unit **120.** The support structures **150** function to raise, carry, and maintain the upper containment unit **120** above the lower containment unit **110** without imparting any weight bearing forces onto the lower containment unit **110.** The raising of the upper containment unit **120** above the lower containment unit **110** by the support structures **150** produces an isolation gap **105** between the lower containment unit **110** and the upper containment unit **120.**

However, it will be appreciated that in other implementations, the upper containment unit **120** may be supported by, and provide weight bearing forces onto, the lower containment unit **110.** It will be appreciated that, for purposes of the instant disclosure, whether the upper containment unit **120** imparts weight bearing forces onto the lower containment unit **110** is not limiting with regard to the inventive concepts presented herein.

The vertically-stacked multilevel modular datacenter **100** are configured to house multitudes of racks containing electronic processing components *(not shown),* such as, computer server, specialized processors, memory components, high-speed network modules, *etc.* and electrical equipment. Accordingly, the lower and upper containment units **110, 120** require the installation of electrical equipment/facilities to support and service the power needs of the electronic processing racks. As will be described in greater detail below, the instant disclosure presents various embodiments that provide an electric infrastructure and configuration layout to optimize the electrically-communicative cabling connectivity within the limited spaces of the lower and upper containment units **110, 120** as well as between the lower and upper containment units **110, 120.**

With this said, as shown in FIG. 1, the vertically-stacked multilevel modular datacenter **100** implements certain openings and conduit structures to accommodate the routing of electrically-communicative cabling and piping between the lower and upper containment units **110, 120.** Specifically, the lower containment unit **110** incorporates at least one upper porthole **110A-D** disposed on a roof surface of the lower containment unit **110** while the upper containment unit **120** incorporates at least one lower porthole **120A-D** disposed on a floor surface of the upper containment unit **120.** The at least one upper porthole **110A-D** of the lower containment unit **110** and the at least one lower porthole **120A-D** upper containment unit **120** are positioned and arranged to be vertically aligned with each other.

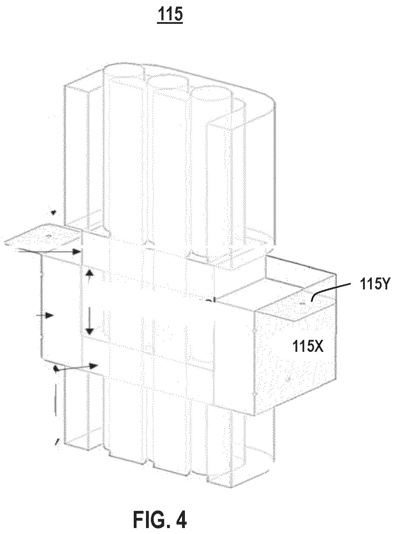

Relatedly, the vertically-stacked multilevel modular datacenter **100** incorporates at least one electric conduit structure **115A-D,** disposed between the lower containment unit **110** and upper containment unit **120** (*i.e*., mounted within the isolation gap **105**), and configured to be positionally aligned with the at least one upper porthole **110A-D** and the at least one lower porthole **120A-D.** As best seen in FIG. 4, which depicts a perspective cross sectional view of the at least one electric conduit component **115A-D,** in accordance with non-limiting embodiments of the present disclosure, the at least one electric conduit component **115A-D** comprises an internal channelized structure for guiding the routing of the electrically-communicative cabling and an external structure embodying water- and fire-proof materials for the protection of the routed electrically-communicative cabling. In some implementations, the external structure of the at least one electric conduit component **115A-D** may comprise one or more of the following elements: metal sleeves, firestop collars, intumescent strips, water-proof materials, and fire-resistant materials.

According to the present invention, the at least one electric conduit component **115A-D** comprises a vertically-arranged skirt portion **115X** to facilitate the slidable positioning between the at least one upper porthole **110A-D** and the at least one lower porthole **120A-D** thereof as well as a horizontally-arranged attachment tab **115Y** to facilitate the secure fastening thereof to the lower containment unit **110.**

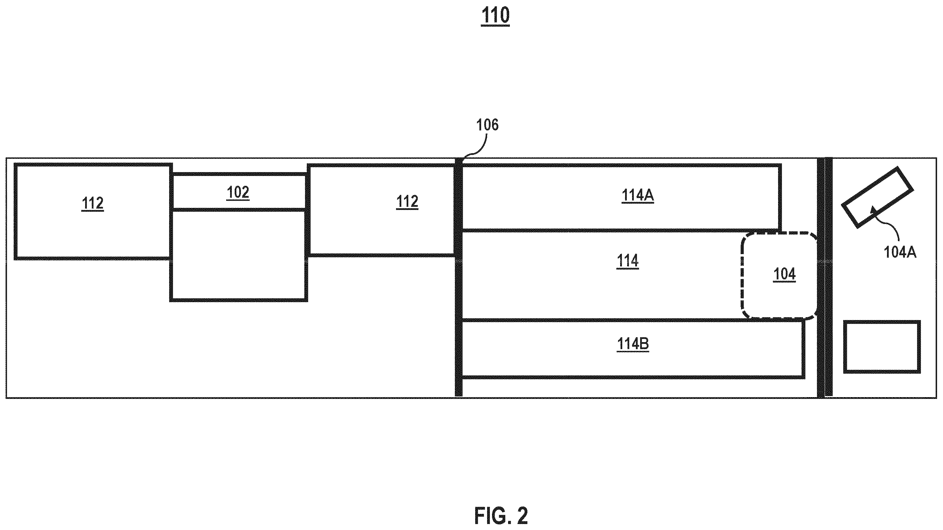

Moving to FIG. 2, depicting a top view of an internal layout configuration of the lower containment unit **110** of the multilevel modular datacenter **100,** in accordance with non-limiting embodiments of the present disclosure. The lower containment unit **110** is configured to house at least one uninterruptible power supply unit (UPS) **112,** a UPS air handler **102,** at least one power distribution center system (PDCS) **114,** and a PDCS air-cooling system **104.** As shown, the UPS **112** and UPS air handler **102** are internally disposed in a first section on one side of the lower containment unit **110** while the PDCS **114** and PDCS air-cooling system **104** are internally disposed in a second section on an opposite side of the lower containment unit **110.** The opposite first and second sections of the lower containment unit **110** are generally separated by an air-cooling partition wall **106.**

The UPS **112** is configured to provide automated backup power in the event of main/utility power source outages or failures and, upon detecting an outage/failure, utilizes a battery assembly **122** of the upper containment unit **120** (described below) to supply continual back-up power.

The UPS air handler **102** is configured to provide air-cooling of the section containing the UPS **112.** The UPS air handler **102** is designed to be installed typically in power rooms as well as IT rooms to assure sufficient heat treatment. The UPS air handler **102** is fluidly-connected to pumping module *(not shown),* which is linked to a dry cooler *(not shown),* and comprises finned heat exchangers (FHEXs) and fans *(not shown).* Hot air is collected by the fans due to a plenum installed over the UPS **112** and the air handler **102** to create a hot aisle. Hot air then passes through the FHEXs to be cooled by the cold water supplied by the dry coolers. Cold air exiting the air handler **102** is re-sucked by the heat source. The air handler **102** fans may be in the hot or in the cold aisles, in other words, before or after the FHEXs. In the depicted embodiment, two air handlers **102** are installed for reduced risk, in which is each air handler **102** can deliver for example 20kW of cooling capacity. In this manner, if an air handler **102** is out of commission due to malfunction or maintenance, the second air handler **102** would be able to support the UPSs load in a degraded mode.

The PDCS **114** comprises at least one power distribution center (PDC) **114A** and at least one power distribution center UPS (PDCU) **114B.** The at least one PDC **114A** distributes, monitors, controls, and optimizes power allocation to the numerous components of both the lower and upper containment units **110, 120.** The at least one PDC **114A** is fed from power sources comprising a power transformer, a generator, and back-up source which are mechanically and electrically interlocked between each other (closed transition). An internal PLC manages the sources as well as the PMS. Local switches also manage the PMS from the battery container, the power container, and the BMS. The PDC **114A** conforms to the IEC 61439-2 Standard and feeds different non-UPS loads, and 1 or 2 UPS depending on the UPS rated power. The PDC **114A** is configured to be strategically positioned to house and support PDCUs **114B,** the positioning of which is arranged to minimize the required electrical cable lengths to the numerous components of both the lower and upper containment units **110, 120** of the multilevel modular datacenter **100.**

The least one PDCU **114B** is fed from the UPS **112** output and/or from the PDC **114A.** The PDCU **114B** is electrically- and communicatively-coupled to the UPS **112,** PDC **114A,** and cooling system of the lower containment unit **110.** It is mainly dedicated to feed IT loads through MCCB (Molded Case Circuit breakers) with electronic trip units. The PDC **114B** conforms to the IEC 61439-2 Standard.

The PDCS air-cooling system **104** comprises an air conditioning condenser **104A** to remove heated air from the section containing the at least one PDC **114A** and the at least one PDCU **114B** and provide cooling air therethrough.

As such, the air-cooling partition wall **106** of the lower containment unit **110** operates to separate and isolate the air-cooling operations of the respective first and second sections containing the at least one UPS **112** from the PDCS **114.**

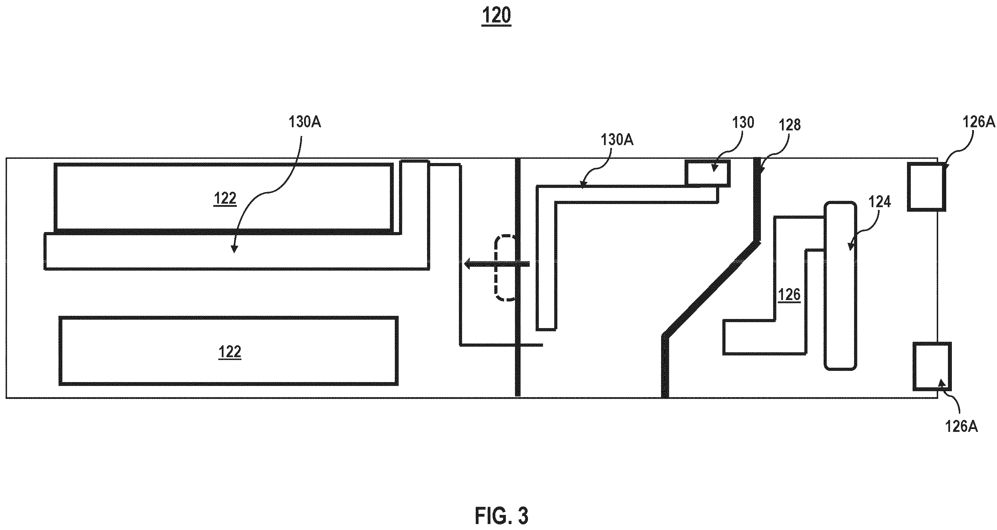

FIG. 3 depicts a top view of an internal layout configuration of the upper containment unit **120** of the multilevel modular datacenter **100,** in accordance with non-limiting embodiments of the present disclosure. As shown, the upper containment unit **120** is configured to house at least one least one battery assembly **122,** a battery assembly air-cooling system **130,** at least one transformer **124,** and a transformer air-cooling system **126.**

The at least one battery assembly **122** and the battery assembly air-cooling system **130** are internally disposed in a first section on one side of the upper containment unit **120.** The positioning of the at least one battery assembly **122** is proximately vertically-aligned with the positioning of the UPS **112** of the lower containment unit **110.**

The at least one transformer **124** and the transformer air-cooling system **126** are internally disposed in a second section on an opposite side of the upper containment unit **120** that is generally separated from the by an air-cooling partition wall **128.** The positioning of the at least one transformer **124** is proximately vertically-aligned with the positioning of the PDCS **114** of the lower containment unit **110.**

The at least one transformer **124** is configured to convert the voltage levels supplied by the main/utility power source to voltage levels acceptable to service the power needs required by the electronic processing racks.

The transformer air-cooling system **126** comprises at least one air ventilation fan unit **126** that serves to remove heated air from that section of the upper containment unit **120** onto the external ambient environment and provide cooling air therethrough.

The at least one battery assembly **122** is communicatively coupled to the UPS **112** of the lower containment unit **110** and is configured to store sufficient electric charge levels to supply the necessary power to the electronic processing racks in the event of main/utility power source outages or failures.

The battery assembly air-cooling system **130** comprises an air conditioning unit configured to supply cooled air via a ventilation duct configuration **130A.** The air-cooling partition wall **128** of the upper containment unit **120** operates to separate and isolate the air-cooling operations of the respective sections containing the at least one battery assembly **122** from the at least one transformer **124.** In addition, the partition wall **128** provides protection to operators inside the aisle in case of fire due transformer malfunction **124.**

As detailed above, the disclosed embodiments provide that the positioning of the at least one battery assembly **122** of the upper containment unit **120** is proximately vertically-aligned with the positioning of the UPS **112** of the lower containment unit **110.** The disclosed embodiments further provide that the positioning of the at least one transformer **124** of the upper containment unit **120** is proximately vertically-aligned with the positioning of the PDCS **114** of the lower containment unit **110.**

It should be appreciated that the disclosed layout positioning of the battery assembly **122** to be proximately vertically-aligned with the UPS **112** and the transformer **124** to be proximately vertically-aligned with the PDC **114A,** provides a multilevel modular datacenter **100** configuration that substantially minimizes the required electrical cable lengths as well as reducing installation complexity and associated costs.

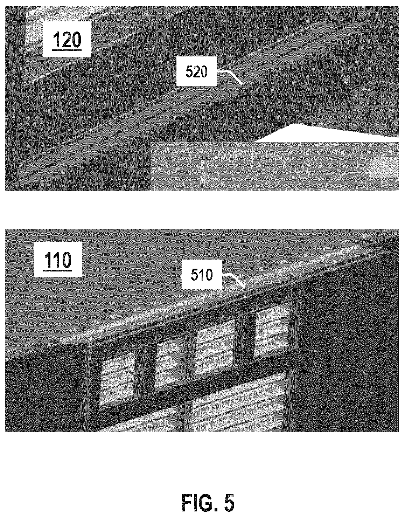

FIG. 5 depicts a moisture protection cap structure **510** and a junction structure **520** for the multilevel modular datacenter **100,** in accordance with non-limiting embodiments of the present disclosure. In particular, the moisture protection cap structure **510** is externally attached to an edge of the roof surface of the lower containment unit **110.** The moisture protection cap structure **510** is configured and operates to divert any moisture from rain or snow away from the at least one electric conduit structure **115A-D.** The moisture protection cap structure **510** may comprise any suitable material, such as, metal, plastic, *etc.* that can be formed with a surface that directs moisture away from the position of the at least one electric conduit structure **115A-D.**

The junction structure **520** is externally attached to on an edge of the floor surface of the upper containment unit **110.** The junction structure **520** is configured and operates to facilitate engagement and provide a stable platform for adjoining an additional lower containment unit **110.** In the depicted embodiment, the junction structure **520** comprises a toothed outer edge profile but other suitable outer edge profiles, such as, dovetail, scallop, *etc.* are contemplated.

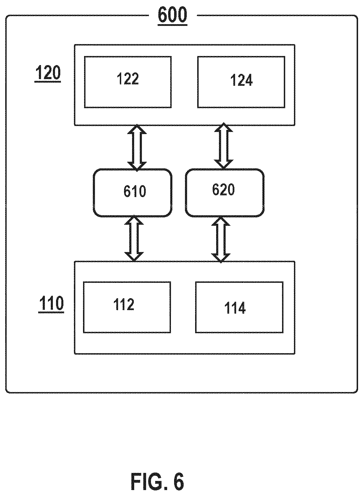

FIG. 6 depicts a functional block diagram of a global monitoring system (GMS) **600** for the multilevel modular datacenter **100,** in accordance with non-limiting embodiments of the present disclosure. The GMS **600** is configured and operates to monitor the status of communicatively-coupled operational sensors of various components of the lower and upper containment units **110, 120,** detect any failures or anomalies, and notify operators of any potential issues. As shown, GMS **600** comprises a power monitoring subsystem (PMS) **610,** a temperature/humidity monitoring subsystem (TMS) **620** and a building equipment monitoring subsystem (BEMS) **630.**

The PMS **610** comprises communicatively-coupled current, voltage, and/or power sensors *(not shown)* coupled to the UPS **112,** PDC **114A,** PDCU **114B,** and cooling system of the lower containment unit **110** as well as coupled to the battery assembly **122** and transformer **124** of the upper containment unit **120.** The PMS **610** monitors the power and electrical consumption status of these components and can detect any failures or anomalies and report any potential electrical or power issues to operators.

The BMS **620** comprises communicatively-coupled temperature and humidity sensors *(not shown)* coupled to the PDC **114A,** and cooling system of the lower containment unit **110** as well as coupled to the battery assembly **122** and transformer **124** of the upper containment unit **120.** The BMS **620** monitors the temperature and humidity levels experienced by these components and reports any potential heat or humidity issues to operators.

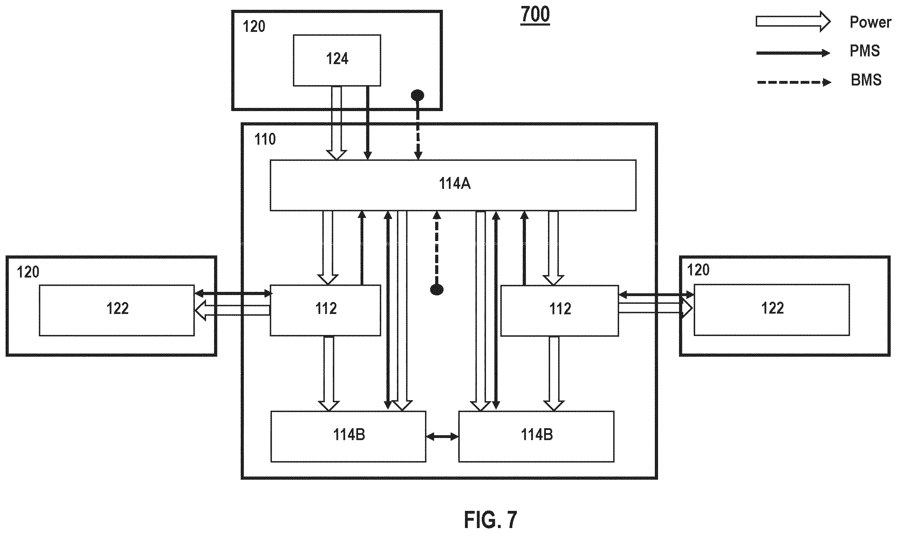

FIG. 7 depicts a functional block diagram of an electrical distribution infrastructure **700** for the multilevel modular datacenter **100,** in accordance with non-limiting embodiments of the present disclosure. As shown, electrical distribution infrastructure **700** is communicatively-coupled to the UPS **112** and PDCS **114** of the lower containment unit **110** as well as the communicatively-coupled battery assembly **122** and transformer **124** of the upper containment unit **120.**

The electrical distribution infrastructure **700** is configured to provide the electrical power to the UPS **112** and PDC **114A,** PDCU **114B** of the lower containment unit **110** as well as the battery assembly **122** and transformer **124** of the upper containment unit **120.** The electrical distribution infrastructure **700** comprises the cabling facilities and layout positioning of the battery assembly **122** to be proximately vertically-aligned with the UPS **112** and the transformer **124** to be proximately vertically-aligned with the PDC **114A.** The electrical distribution infrastructure **700** also comprises cabling facilities to support and provide communications to the electrical circuit elements, such as, fuses, switches, *etc.* associated with the BMS **620.**

In this manner, the disclosed embodiments provide a multilevel modular datacenter 100 configuration having an electric infrastructure and component configuration layout to optimize the limited spaces within multilevel modular datacenters that substantially minimizes required electrical cable lengths and reduces installation complexity and associated costs.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A multi-level modular datacenter (100) for data processing equipment, comprising:
a lower containment unit (110) housing at least one uninterruptible power supply unit (112), at least one power distribution center system (114), and at least one upper porthole (110A-D) disposed on a roof surface of the lower containment unit (110);
an upper containment unit (120) arranged to be aligned and vertically disposed directly above the lower containment unit (110), the upper containment unit (120) housing at least one battery assembly (122), at least one transformer (124), and at least one lower porthole (120A-D) disposed on a floor surface of the upper containment unit (120);
an electrical distribution infrastructure (700) comprising electrically-communicative cabling to service the lower and upper containment units (110, 120), the electrical distribution infrastructure (700) configured to enable electrical communications of components within each of the lower and upper containment units (110, 120) and enable electrical communications between components of the lower and upper containment units (110, 120); and
at least one electric conduit component (115A-D), disposed between the lower containment unit (110) and upper containment unit (120), configured to be aligned with the at least one upper porthole (110A-D) and the at least one lower porthole (120A-D) to accommodate routing of the electrically-communicative cabling between the lower (110) and upper containment (120) units, the electric conduit component (115A-D) comprising:
a vertically-arranged skirt portion (115X) to facilitate slidable positioning between the at least one upper porthole (110A-D) and the at least one lower porthole (120A-D);
a horizontally-arranged attachment tab (115Y) to facilitate secure fastening to the lower containment unit (110); and
one or more of the following material elements: metal sleeves, firestop collars, intumescent strips, water-proof materials, and fire-resistant materials,
wherein the positioning of the at least one battery assembly (122) of the upper containment unit (120) is arranged to be vertically-aligned with the positioning of the uninterruptible power supply unit (112) of the lower containment unit (110) and the positioning of the at least one transformer (124) of the upper containment unit (120) is arranged to be vertically-aligned with the positioning of the power distribution center system (114) of the lower containment unit (110).

2. The multi-level modular datacenter of claim 1, wherein the power distribution center system (114) comprises at least one power distribution center (114A) and at least one power distribution center uninterruptible power supply unit (114B).

3. The multi-level modular datacenter of claim 2, wherein the power distribution center system (114B) is configured to supply electrical power and be electrically- and communicatively-coupled to the uninterruptible power supply unit (112) of the lower containment unit (110) and to the battery assembly (122) and transformer (124) of the upper containment unit (120).

4. The multi-level modular datacenter of anyone of claims 1 to 3, further incorporating a global monitoring system (600) configured to monitor the status of communicatively-coupled operational sensors of various components of the lower and upper containment units (110, 120), the global monitoring system (600) comprising:
a power monitoring subsystem (610) configured to monitor status of power and electrical consumption of associated components; and
a temperature/humidity monitoring subsystem (620) configured to monitor status of temperature and humidity levels of associated components.

5. The multi-level modular datacenter of claim 4, wherein the global monitoring system (600) is further configured to provide notifications of any detected failures, malfunctions, and/or any potential issues based on the monitored status of the power monitoring subsystem (610) and temperature/humidity monitoring subsystem (620).

6. The multi-level modular datacenter of any one of claims 1 to 5, wherein the lower containment unit (110) comprises an air-cooling partition wall (106) that operates to separate and isolate the air-cooling operations of the respective first and second sections containing the at least one uninterruptible power supply unit (112) from the power distribution center system (114).

7. The multi-level modular datacenter of any one of claims 1 to 6, wherein the upper containment unit (120) comprises an air-cooling partition wall (128) to separate and isolate the air-cooling operations of the respective sections containing the at least one battery assembly (122) from the at least one transformer (124).

8. The multi-level modular datacenter of any one of claims 1 to 7, wherein the at least one electric conduit component (115A-D) comprises an internal channelized structure for guiding the routing of the electrically-communicative cabling and an external structure embodying water- and fire-proof material for protection of the routed electrically-communicative cabling.

9. The multi-level modular datacenter of any one of claims 1 to 8, wherein the electrical distribution infrastructure (700) is configured to provide electrical communications by interconnecting:
the at least one uninterruptible power supply unit (112) with the at least one power distribution center system (114) of the lower containment unit (110);
the at least one battery assembly (122) with the at least one transformer (124) of the upper containment unit (120).

10. The multi-level modular datacenter of any one of claims 1 to 9, wherein the electrical distribution infrastructure (700) is further configured to provide electrical communications by interconnecting:
the at least one uninterruptible power supply unit (112) of the lower containment unit (110) with the at least one battery assembly (122) of the upper containment unit (120); and
the at least one power distribution center system (114) of the lower containment unit (110) with the at least one transformer (124) of the upper containment unit (120).

11. The multi-level modular datacenter of any one of claims 1 to 10, wherein the lower containment unit (110) further comprises a moisture protection cap structure (510), externally attached on an edge of the roof surface of the lower containment unit (110), configured to divert any moisture from rain or snow away from the at least one electric conduit structure (115A-D).

12. The multi-level modular datacenter of any one of claims 1 to 11, wherein the upper containment unit (120) further comprises a junction structure (520), externally disposed on an edge of the floor surface of the upper containment unit (120), configured to facilitate engagement and provide a stable platform for adjoining an additional upper containment unit (120).

## Patentansprüche

1. Mehrstufiges modulares Datencenter (100) für Datenverarbeitungsgeräte, umfassend:
eine untere Einschlusseinheit (110), in der mindestens eine unterbrechungsfreie Stromversorgungseinheit (112) untergebracht ist, mindestens ein Stromverteilungszentrumsystem (114) und mindestens eine obere Durchlassöffnung (110A-D), die auf einer Dachfläche der unteren Einschlusseinheit (110) angeordnet ist;
eine obere Einschlusseinheit (120), die so angeordnet ist, dass sie direkt über der unteren Einschlusseinheit (110) ausgerichtet und vertikal angeordnet ist, wobei in der oberen Einschlusseinheit (120) mindestens eine Batteriebaugruppe (122), mindestens ein Transformator (124) und mindestens eine untere Durchlassöffnung (120A-D), die auf einer Bodenfläche der oberen Einschlusseinheit (120) angeordnet ist, untergebracht sind;
eine elektrische Verteilungsinfrastruktur (700), die elektrisch kommunizierende Verkabelung umfasst, um die unteren und oberen Einschlusseinheiten (110, 120) zu versorgen, wobei die elektrische Verteilungsinfrastruktur (700) so konfiguriert ist, dass sie die elektrische Kommunikation von Komponenten innerhalb jeder der unteren und oberen Einschlusseinheiten (110, 120) und die elektrische Kommunikation zwischen Komponenten der unteren und oberen Einschlusseinheiten (110, 120) ermöglicht; und
mindestens ein elektrisches Durchleitungselement (115A-D), das zwischen der unteren Einschlusseinheit (110) und der oberen Einschlusseinheit (120) angeordnet ist und so konfiguriert ist, dass sie mit der mindestens einen oberen Durchlassöffnung (110A-D) und der mindestens einen unteren Durchlassöffnung (120A-D) ausgerichtet ist, um die Führung der elektrisch kommunizierenden Verkabelung zwischen der unteren (110) und der oberen (120) Einschlusseinheit zu ermöglichen, wobei das elektrische Durchleitungselement (115A-D) Folgendes umfasst:
ein vertikal angeordnetes Mantelteil (115X), um eine verschiebbare Positionierung zwischen der mindestens einen oberen Durchlassöffnung (110A-D) und der mindestens einen unteren Durchlassöffnung (120A-D) zu erleichtern;
eine horizontal angeordnete Befestigungslasche (115Y), um eine sichere Befestigung an der unteren Einschlusseinheit (110) zu erleichtern; und
ein oder mehrere der folgenden Materialelemente: Metallhülsen, Brandschutzkragen, intumeszierende Streifen, wasserdichte Materialien und feuerbeständige Materialien,
wobei die Positionierung der mindestens einen Batteriebaugruppe (122) der oberen Einschlusseinheit (120) so angeordnet ist, dass sie vertikal mit der Positionierung der unterbrechungsfreien Stromversorgungseinheit (112) der unteren Einschlusseinheit (110) vertikal ausgerichtet ist und die Positionierung des mindestens einen Transformators (124) der oberen Einschlusseinheit (120) so angeordnet ist, dass sie vertikal mit der Positionierung des Stromverteilungszentrumsystems (114) der unteren Einschlusseinheit (110) ausgerichtet ist.

2. Mehrstufiges modulares Datencenter nach Anspruch 1, wobei das Stromverteilungszentrumsystem (114) mindestens ein Stromverteilungszentrum (114A) und mindestens eine unterbrechungsfreie Stromversorgungseinheit (114B) des Stromverteilungszentrums umfasst.

3. Mehrstufiges modulares Datencenter nach Anspruch 2, wobei das Stromverteilungszentrumsystem (114B) so konfiguriert ist, dass es elektrische Energie liefert und elektrisch und kommunikativ mit der unterbrechungsfreien Stromversorgungseinheit (112) der unteren Einschlusseinheit (110) und mit der Batteriebaugruppe (122) und dem Transformator (124) der oberen Einschlusseinheit (120) gekoppelt ist.

4. Mehrstufiges modulares Datencenter nach einem der Ansprüche 1 bis 3, ferner umfassend ein globales Überwachungssystem (600), das so konfiguriert ist, dass es den Status von kommunikativ gekoppelten Betriebssensoren verschiedener Komponenten der unteren und oberen Einschlusseinheiten (110, 120) überwacht, wobei das globale Überwachungssystem (600) Folgendes umfasst:
ein Stromüberwachungssubsystem (610), das so konfiguriert ist, dass es den Status der Stromversorgung und des Stromverbrauchs der zugehörigen Komponenten überwacht; und
ein Temperatur-/Feuchtigkeitsüberwachungssubsystem (620), das so konfiguriert ist, dass es den Status der Temperatur- und Feuchtigkeitswerte der zugehörigen Komponenten überwacht.

5. Mehrstufiges modulares Datencenter nach Anspruch 4, wobei das globale Überwachungssystem (600) ferner so konfiguriert ist, dass es Benachrichtigungen über erkannte Ausfälle, Fehlfunktionen und/oder potenzielle Probleme auf der Grundlage des überwachten Status des Stromüberwachungssubsystems (610) und des Temperatur-/Feuchtigkeitsüberwachungssubsystems (620) bereitstellt.

6. Mehrstufiges modulares Datencenter nach einem der Ansprüche 1 bis 5, wobei die untere Einschlusseinheit (110) eine Luftkühlungstrennwand (106) umfasst, die dazu dient, die Luftkühlungsvorgänge des jeweiligen ersten und zweiten Abschnitts, die die mindestens eine unterbrechungsfreie Stromversorgungseinheit (112) enthalten, vom Stromverteilungszentrumsystem (114) zu trennen und zu isolieren.

7. Mehrstufiges modulares Datencenter nach einem der Ansprüche 1 bis 6, wobei die obere Einschlusseinheit (120) eine Luftkühlungstrennwand (128) umfasst, um die Luftkühlungsvorgänge der jeweiligen Abschnitte, die die mindestens eine Batteriebaugruppe (122) enthalten, von dem mindestens einen Transformator (124) zu trennen und zu isolieren.

8. Mehrstufiges modulares Datencenter nach einem der Ansprüche 1 bis 7, wobei das mindestens eine elektrische Durchleitungselement (115A-D) eine interne kanalisierte Struktur zum Führen der elektrisch kommunizierenden Verkabelung und eine externe Struktur aus wasser- und feuerbeständigem Material zum Schutz der geführten elektrisch kommunizierenden Verkabelung umfasst.

9. Mehrstufiges modulares Datencenter nach einem der Ansprüche 1 bis 8, wobei die elektrische Verteilungsinfrastruktur (700) so konfiguriert ist, dass sie elektrische Kommunikation bereitstellt, indem sie Folgendes miteinander verbindet:
die mindestens eine unterbrechungsfreie Stromversorgungseinheit (112) mit dem mindestens einen Stromverteilungszentrumsystem (114) der unteren Einschlusseinheit (110);
die mindestens eine Batteriebaugruppe (122) mit dem mindestens einen Transformator (124) der oberen Einschlusseinheit (120).

10. Mehrstufiges modulares Datencenter nach einem der Ansprüche 1 bis 9, wobei die elektrische Verteilungsinfrastruktur (700) ferner so konfiguriert ist, dass sie elektrische Kommunikation bereitstellt, indem sie Folgendes miteinander verbindet:
die mindestens eine unterbrechungsfreie Stromversorgungseinheit (112) der unteren Einschlusseinheit (110) mit der mindestens einen Batteriebaugruppe (122) der oberen Einschlusseinheit (120); und
das mindestens eine Stromverteilungszentrumsystem (114) der unteren Einschlusseinheit (110) mit dem mindestens einen Transformator (124) der oberen Einschlusseinheit (120).

11. Mehrstufiges modulares Datencenter nach einem der Ansprüche 1 bis 10, wobei die untere Einschlusseinheit (110) ferner eine Feuchtigkeitsschutzkappenkonstruktion (510) umfasst, die außen an einer Kante der Dachfläche der unteren Einschlusseinheit (110) angebracht ist und so konfiguriert ist, dass sie Feuchtigkeit durch Regen oder Schnee von der mindestens einen elektrischen Durchleitungskonstruktion (115A-D) ableitet.

12. Mehrstufiges modulares Datencenter nach einem der Ansprüche 1 bis 11, wobei die obere Einschlusseinheit (120) ferner eine Verbindungsstruktur (520) umfasst, die außen an einer Kante der Bodenfläche der oberen Einschlusseinheit (120) angeordnet ist und so konfiguriert ist, dass sie den Eingriff erleichtert und eine stabile Plattform für die Anbindung einer zusätzlichen oberen Einschlusseinheit (120) bietet.

## Revendications

1. Centre de données modulaire multiniveau (100) pour équipement de traitement de données, comprenant :
une unité de confinement inférieure (110) logeant au moins une unité d'alimentation en puissance sans interruption (112), au moins un système de centre de distribution de puissance (114) et au moins un hublot supérieur (110A-D) disposé sur une surface de toit de l'unité de confinement inférieure (110) ;
une unité de confinement supérieure (120) agencée pour être alignée et disposée verticalement directement au-dessus de l'unité de confinement inférieure (110), l'unité de confinement supérieure (120) logeant au moins un ensemble de batteries (122), au moins un transformateur (124) et au moins un hublot inférieur (120A-D) disposé sur une surface de plancher de l'unité de confinement supérieure (120) ;
une infrastructure de distribution électrique (700) comprenant un câblage de communication électrique pour desservir les unités de confinement inférieure et supérieure (110, 120), l'infrastructure de distribution électrique (700) étant configurée pour permettre les communications électriques des composants au sein de chacune des unités de confinement inférieure et supérieure (110, 120) et permettre les communications électriques entre les composants des unités de confinement inférieure et supérieure (110, 120) ; et
au moins un composant de conduit électrique (115A-D), disposé entre l'unité de confinement inférieure (110) et l'unité de confinement supérieure (120), configuré pour être aligné avec l'au moins un hublot supérieur (110A-D) et l'au moins un hublot inférieur (120A-D) afin de recevoir le routage du câblage de communication électrique entre les unités de confinement inférieure (110) et supérieure (120), le composant de conduit électrique (115A-D) comprenant :
une partie jupe (115X) agencée verticalement pour faciliter le positionnement coulissant entre l'au moins un hublot supérieur (110A-D) et l'au moins un hublot inférieur (120A-D) ;
une languette de fixation (115Y) agencée horizontalement pour faciliter la fixation sécurisée à l'unité de confinement inférieure (110) ; et
l'un ou plusieurs des éléments matériels suivants : manchons métalliques, colliers coupe-feu, bandes intumescentes, matériaux imperméables à l'eau et matériaux résistants au feu, dans lequel le positionnement de l'au moins un ensemble de batteries (122) de l'unité de confinement supérieure (120) est agencé pour être aligné verticalement avec le positionnement de l'unité d'alimentation en puissance sans interruption (112) de l'unité de confinement inférieure (110) et le positionnement de l'au moins un transformateur (124) de l'unité de confinement supérieure (120) est agencé pour être aligné verticalement avec le positionnement du système de centre de distribution de puissance (114) de l'unité de confinement inférieure (110).

2. Centre de données modulaire multiniveau selon la revendication 1, dans lequel le système de centre de distribution de puissance (114) comprend au moins un centre de distribution de puissance (114A) et au moins une unité d'alimentation en puissance sans interruption (114B) de centre de distribution de puissance.

3. Centre de données modulaire multiniveau selon la revendication 2, dans lequel le système de centre de distribution de puissance (114B) est configuré pour alimenter de la puissance électrique et être couplé électriquement et de manière communicative à l'unité d'alimentation en puissance sans interruption (112) de l'unité de confinement inférieure (110) et à l'ensemble de batteries (122) et au transformateur (124) de l'unité de confinement supérieure (120).

4. Centre de données modulaire multiniveau selon l'une quelconque des revendications 1 à 3, incorporant également un système de surveillance global (600) configuré pour surveiller l'état de capteurs opérationnels couplés en communication de divers composants des unités de confinement inférieure et supérieure (110, 120), le système de surveillance global (600) comprenant :
un sous-système de surveillance de puissance (610) configuré pour surveiller l'état de la puissance et la consommation électrique des composants associés ; et
un sous-système de surveillance de température/humidité (620) configuré pour surveiller l'état des niveaux de température et d'humidité des composants associés.

5. Centre de données modulaire multiniveau selon la revendication 4, dans lequel le système de surveillance global (600) est également configuré pour fournir des notifications d'un ou une quelconque défaillance, dysfonctionnement et/ou problème potentiel détectés en fonction de l'état surveillé du sous-système de surveillance de puissance (610) et du sous-système de surveillance de température/humidité (620).

6. Centre de données modulaire multiniveau selon l'une quelconque des revendications 1 à 5, dans lequel l'unité de confinement inférieure (110) comprend une paroi de séparation de refroidissement par air (106) qui opère pour séparer et isoler les opérations de refroidissement par air des première et seconde sections respectives contenant l'au moins une unité d'alimentation en puissance sans interruption (112) du système de centre de distribution de puissance (114).

7. Centre de données modulaire multiniveau selon l'une quelconque des revendications 1 à 6, dans lequel l'unité de confinement supérieure (120) comprend une paroi de séparation de refroidissement par air (128) pour séparer et isoler les opérations de refroidissement par air des première et seconde sections respectives contenant l'au moins un ensemble de batteries (122) de l'au moins un transformateur (124).

8. Centre de données modulaire multiniveau selon l'une quelconque des revendications 1 à 7, dans lequel l'au moins un composant de conduit électrique (115A-D) comprend une structure canalisée interne pour guider le routage du câblage de communication électrique et une structure externe intégrant un matériau imperméable à l'eau et résistant au feu pour la protection du câblage de communication électrique routé.

9. Centre de données modulaire multiniveau selon l'une quelconque des revendications 1 à 8, dans lequel l'infrastructure de distribution électrique (700) est configurée pour fournir des communications électriques en interconnectant :
l'au moins une unité d'alimentation en puissance sans interruption (112) avec l'au moins un système de centre de distribution de puissance (114) de l'unité de confinement inférieure (110) ;
l'au moins un ensemble de batteries (122) avec l'au moins un transformateur (124) de l'unité de confinement supérieure (120).

10. Centre de données modulaire multiniveau selon l'une quelconque des revendications 1 à 9, dans lequel l'infrastructure de distribution électrique (700) est également configurée pour fournir des communications électriques en interconnectant :
l'au moins une unité d'alimentation en puissance sans interruption (112) de l'unité de confinement inférieure (110) avec l'au moins un ensemble de batteries (122) de l'unité de confinement supérieure (120) ; et
l'au moins un système de centre de distribution de puissance (114) de l'unité de confinement inférieure (110) avec l'au moins un transformateur (124) de l'unité de confinement supérieure (120).

11. Centre de données modulaire multiniveau selon l'une quelconque des revendications 1 à 10, dans lequel l'unité de confinement inférieure (110) comprend également une structure de capuchon de protection contre l'humidité (510), fixée à l'extérieur sur un bord de la surface de toit de l'unité de confinement inférieure (110), configurée pour détourner une quelconque humidité provenant de la pluie ou de la neige de l'au moins une structure de conduit électrique (115A-D).

12. Centre de données modulaire multiniveau selon l'une quelconque des revendications 1 à 11, dans lequel l'unité de confinement supérieure (120) comprend également une structure de jonction (520), disposée à l'extérieur sur un bord de la surface de plancher de l'unité de confinement supérieure (120), configurée pour faciliter la mise en prise et fournir une plate-forme stable pour rejoindre une unité de confinement supérieure (120) supplémentaire.
